# EUROPÄISCHE PATENTSCHRIFT

(11) **EP 3 185 312 B1**
(45) Veröffentlichungstag und Bekanntmachung des Hinweises auf die Patenterteilung: **08.02.2023**
(21) Anmeldenummer: 16002595.3
(22) Anmeldetag: 06.12.2016
(51) Int. Cl.: H01L 31/0687, H01L 31/0304, H01L 31/041

(54) **STAPELFÖRMIGE MEHRFACH-SOLARZELLE**
STACKABLE MULTIJUNCTION SOLAR CELL
CELLULE SOLAIRE MULTI-JONCTIONS DISPOSÉES EN PILES

(30) Priorität: 25.12.2015 DE 102015016822
(43) Veröffentlichungstag der Anmeldung: 28.06.2017
(73) Patentinhaber: AZUR SPACE Solar Power GmbH, 74072 Heilbronn (DE)
(72) Erfinder: Guter, Wolfgang, 70190 Stuttgart (DE); Meusel, Matthias, 74076 Heilbronn (DE); Roesener, Tobias, 81369 München (DE)
(74) Vertreter: Koch Müller Patentanwaltsgesellschaft mbH

(56) Entgegenhaltungen:
- CN-A- 102 299 159
- CN-A- 103 151 413
- CN-A- 103 346 191
- US-A- 4 017 332
- US-A1- 2006 144 435
- US-B2- 8 969 712
- SUN Y R ET AL: "Effects of temperature and substrate miscut on the crystalline quality of metamorphic AlInAs layers grown on GaAs substrate", JOURNAL OF CRYSTAL GROWTH, Bd. 381, 16. Juli 2013 (2013-07-16), Seiten 70-76, XP028712988, ISSN: 0022-0248, DOI: 10.1016/J.JCRYSGRO.2013.07.014
- SHARPS P R ET AL: "GaInAsP lattice matched to GaAs for solar cell applications", PROCEEDINGS OF THE PHOTOVOLTAIC SPECIALISTS CONFERENCE. LAS VEGAS, OCT. 7 - 11, 1991; [PROCEEDINGS OF THE PHOTOVOLTAIC SPECIALISTS CONFERENCE], NEW YORK, IEEE, US, vol. CONF. 22, 7 October 1991 (1991-10-07) , pages 315-317, XP010039185, DOI: 10.1109/PVSC.1991.169230 ISBN: 978-0-87942-636-1

## Beschreibung

Die Erfindung betrifft eine stapelförmige Mehrfach-Solarzelle.

Aus der Druckschrift "Experimental Results from Performance Improvement and Radiation Hardening of Inverted Metamorphic Multi-Junction Solar Cells" von Patel et al., Proceedings of 37th IEEE PVSC, Seattle (2011), ist eine invertiert metamorphe Vierfach-Solarzelle (IMM4J) mit einem beginning-of-life (BOL) Wirkungsgrad von ca. 34% (AM0) und einem im Vergleich zu handelsüblichen Dreifach-Solarzellen relativ geringen end-of-life (EOL) Restfaktor von ca. 82% bekannt. Die epitaktische Abscheidung auf dem Wachstumssubtrat erfolgt hier im Vergleich zur Anwendung und Ausrichtung der Solarzelle zur Sonne in umgekehrter Reihenfolge (inverted).

Weiterhin sind aus der Druckschrift "Development of Advanced Space Solar Cells at Spectrolab" von Boisvert et al. in Proc. of 35th IEEE PVSC, Honolulu, HI, 2010, ISBN: 978-1-4244-5891-2, eine auf einer Halbleiterbond-Technologie basierende GaInP/GaAs/GaInAsP/GaInAs Vierfach -Solarzellen bekannt.

Eine weitere Vierfach-Solarzelle ist auch aus der Druckschrift "Wafer bonded four-junction GaInP/GaAs/GaInAsP/GaInAs concentrator solar cells with 44.7% efficiency" von Dimroth et al. in Progr. Photovolt: Res. Appl. 2014; 22: 277-282, bekannt. Weitere Mehrfach-Solarzellen sind aus der US 8,969,712 B2 der US 2006/0144435 A1, der US 4,017,332 A sowie aus "Effects of temperature and substrate miscut on the crystalline quality of metamophic AlInAs layers grown on GaAs substrate" von Y.R. Sun et al in Journal of Crystal Growth, Bd. 381, 2013, Seiten 70-76 bekannt.

In den beiden zuletzt genannten beiden Druckschriften werden ausgehend von einem InP Substrat jeweils GaInAsP Solarzellen mit einer Energiebandlücke von ca. 1.0 eV gitterangepasst abgeschieden. Die oberen Solarzellen mit höherer Bandlücke werden in einer zweiten Abscheidung in invertierter

Reihenfolge auf einem GaAs Substrat hergestellt. Die Bildung der gesamten Mehrfach-Solarzelle geschieht durch einen direkten Halbleiterbond der beiden Epitaxiewafer, mit einer anschließenden Entfernung des GaAs Substrates und weiteren Prozessschritten.

Der Herstellungsprozess mittels eines Bonding-Prozesses ist jedoch kostenintensiv und verringert die Ausbeute bei der Herstellung.

Die Optimierung der Strahlungshärte, insbesondere auch für sehr hohe Strahlungsdosen, ist ein wichtiges Ziel bei der Entwicklung zukünftiger Raumfahrtsolarzellen. Ziel ist es neben der Steigerung des Anfangs- bzw. beginning-of-life (BOL) Wirkungsgrades auch den end-of-life (EOL) Wirkungsgrad zu erhöhen.

Weiterhin sind die Herstellungskosten von entscheidender Bedeutung. Der industrielle Standard zum Zeitpunkt der Erfindung ist durch die gitterangepasste und die metamorphe GaInP/GaInAs/Ge Dreifach-Solarzellen gegeben. Hierzu werden durch Abscheidung der GaInP Ober- und GaInAs Mittel-Zelle auf ein relativ zu InP-Substraten kostengünstiges Ge Substrat Mehrfach-Solarzellen hergestellt, wobei das Ge-Substrat die Unterzelle bildet.

Vor diesem Hintergrund besteht die Aufgabe der Erfindung darin, eine Vorrichtung anzugeben, die den Stand der Technik weiterbildet.

Die Aufgabe wird durch eine stapelförmige Mehrfach-Solarzelle mit den Merkmalen des Patentanspruchs 1 gelöst. Vorteilhafte Ausgestaltungen der Erfindung sind Gegenstand von Unteransprüchen.

Gemäß dem Gegenstand der Erfindung wird eine stapelförmige Mehrfach-Solarzelle bereitgestellt, umfassend mindestens drei Tellzellen, wobei jede der drei Teilzellen einen Emitter und eine Basis aufweist, und wobei die erste Teilzelle eine erste Schicht aus einer Verbindung mit wenigstens den Elementen Ga und In und P umfasst und die Energiebandlücke der ersten Schicht größer 1,75 eV ist und die Gitterkonstante der ersten Schicht im Bereich zwischen 5,635 Å und 5,675 Å liegt, und wobei die zweite Teilzelle eine zweite Schicht aus einer Verbindung mit wenigstens den Elementen Ga und As umfasst und die Energiebandlücke der zweiten Schicht im Bereich zwischen 1,35 eV und 1,70 eV liegt und die Gitterkonstante der zweiten Schicht im Bereich zwischen 5,635 Å und 5,675 Å liegt, und wobei die dritte Teilzelle eine dritte Schicht aus einer Verbindung mit wenigstens den Elementen Ga und In und As umfasst und die Energiebandlücke der dritten Schicht kleiner 1,25 eV ist und die Gitterkonstante der dritten Schicht größer 5,700 Å ist. Die Dicke der drei Schichten ist jeweils größer als 100 nm und die drei Schichten sind hierbei als Teil des Emitters und als Teil der Basis der entsprechenden drei Teilzellen ausgebildet. Zwischen der zweiten Teilzelle und der dritten Teilzelle ist ein metamorphe Puffer ausgebildet, wobei der metamorphe Puffer und der metamorphe Puffer eine Abfolge von mindestens drei Schichten aufweist und die Gitterkonstanten der Schichten des Puffers größer als die Gitterkonstante der zweiten Schicht sind und die Gitterkonstante der Schichten des Puffers bei der Abfolge In Richtung zu der dritten Teilzelle von Schicht zu Schicht ansteigt. Mindestens eine der beiden Schichten der zweiten Teilzelle, also die zweite Schicht bzw. der dritten Teilzelle also die dritte Schicht umfasst eine Verbindung mit wenigstens den Elementen Ga und In und As und P und weist ein Phosphor-Gehalt größer als 1% und kleiner als 35% und einen Indium-Gehalt größer 1% auf. Zwischen zwei Teilzellen des gesamten Stapels der Mehrfach-Solarzelle ist kein Halbleiterbond ausgebildet.

Es versteht sich, dass die stapelförmige Mehrfach-Solarzelle monolithisch aufgebaut ist, d.h. zwischen jeweils zwei Teilzellen des Stapels ist kein Halbleiterbond ausgebildet. Des Weiteren versteht es sich, dass zwischen jeweils zwei Teilzellen kein Substrat angeordnet ist. Auch wird angemerkt, dass in jeder der Solarzellen der Mehrfach-Solarzelle eine Absorption von Photonen und hierdurch eine Generation von Ladungsträgern stattfindet, wobei das Sonnenlicht immer zuerst durch die Teilzelle mit der größten Bandlücke eingestrahlt wird. Anders ausgedrückt, der Solarzellenstapel absorbiert mit der obersten Teilzelle zuerst den kurzwelligen Anteil des Lichtes. Vorliegend durchströmen die Photonen also zuerst die erste Teilzelle, anschließend die zweite Teilzelle und dann die dritte Teilzelle. In einem Ersatzschaltbild sind die einzelnen Solarzellen der Mehrfach-Solarzelle in Serie verschaltet, d.h. die Teilzelle mit dem geringsten Strom wirkt limitierend.

Auch sei angemerkt, dass unter den Begriffen Emitter und Basis entweder die p-dotierten oder die n-dotierten Schichten In der jeweiligen Teilzelle verstanden werden.

Es versteht sich, dass die Halbleiterschichten durch epitaktische Verfahren wie beispielsweise MOVPE auf einem Wachstumssubstrat abgeschieden werden. Die für die erste Teilzelle und zweite Teilzelle, bzw. die für die erste Schicht und die zweite Schicht, angeführten Gitterkonstanten-Bereiche entsprechen im Wesentlichen der Gitterkonstanten von einem GaAs Substrat oder einem Ge Substrat. Anders ausgedrückt lassen sich die Abscheidungen der Schichten der einzelnen Teilzellen wenigstes als grob gitterangepasst in Bezug auf die Substrate bezeichnen. Hierbei wird vorliegend von einer invertierten Anordnung der Teilzellen - sogenannten IMM (inverted metamorphic) Zellstapel - während des Herstellungsprozesses gesprochen, d.h. die Zellen mit der höheren Bandlücke werden zuerst hergestellt.

Untersuchungen haben überraschend gezeigt, dass auf GaAs oder Ge Substraten abgeschiedene Teilzellen, sofern die Teilzellen zumindest überwiegend oder vollständig aus einer Verbindung aus GaInAsP bestehen im Vergleich zu Teilzellen aus einer Verbindung aus GaAs oder GaInAs eine höhere Strahlungshärte aufweisen.

Bisher erschien dem Fachmann die Verwendung einer GaInAsP Teilzelle abwegig, da die Abscheidung des quaternären GaInAsP im Vergleich zu GaAs oder GaInAs technisch wesentlich schwieriger ist und sich die Energiebandlücke der Teilzelle durch Beifügen von Phosphor zudem erhöht. Technisch schwieriger heißt unter anderem dass die Flüsse Im Reaktor von wenigstens vier Quellen kontrolliert und eingestellt werden müssen.

Weitere Untersuchungen haben jedoch gezeigt, dass die Erhöhung der Bandlücke durch Phosphor in der invertiert metamorphen Zellarchitektur durch Anpassung des metamorphen Puffers hinsichtlich eines höheren Indium-Gehaltes kompensieren lässt. Eine weitere Möglichkeit besteht in der Erhöhung der Energlebandlücke(n) der unter der GaInAsP Teilzelle angeordneten Tellzelle(n) - z.B. durch die Verwendung von GaInAsP auch für diese Teilzellen - durch welche eine geeignete Bandlückenkombination für die Teilzellen der Mehrfach-Solarzelle gefunden werden kann.

Überraschender Weise lässt sich je nach genauer Ausformung der Mehrfach-Solarzelle auch eine geringfügige Erniedrigung des BOL Wirkungsgrades durch Anwendung von GaInAsP Teilzellen akzeptieren, indem eine signifikante Steigerung des EOL Wirkungsgrades aufgrund der höheren Strahlungsstabilität der GaInAsP Teilzelle(n) erzielt wird.

Es versteht sich, dass insbesondere der angegebene Phosphor-Gehalt auf den Gesamtgehalt der Gruppe-V Atome bezogen ist. Entsprechend ist der angegebene Indium-Gehalt auf den Gesamtgehalt der Gruppe-III Atome bezogen. D.h. bei der Verbindung Ga_{1-X}In_{X}As_{1-Y}P_{Y} beträgt der Indium-Gehalt den Wert X und der Phosphor-Gehalt den Wert Y und hierdurch ergibt sich für einen Phosphor-Gehalt von 50% ein Y-Wert von 0,5.

Es sei angemerkt, dass mit dem Begriff "Halbleiterbond" insbesondere umfasst ist, dass zwischen zwei beliebigen Teilzellen des Solarzellenstapels auch kein direkter Halbleiterbond ausgebildet ist, d.h. der Solarzellestapel wird nicht aus zwei Teilstapeln hergestellt, welche auf unterschiedlichen Substraten abgeschieden wurden und nachträglich über einen Halbleiterbond zusammengefügt sind.

Sogenannte Hetero-Solarzellen mit einem Emitter bestehend aus GaInP und einer Raumladungszone und / oder Basis bestehend aus GaInAs werden nicht als zweite und / oder dritte Teilzelle mit einer Schicht aus einer Verbindung mit wenigstens den Elementen Ga und In und As und P angesehen. Eine Hetero-Solarzellen mit einem Emitter bestehend aus GaInP und einer Raumladungszone und / oder Basis bestehend aus GaInAsP werden jedoch als zweite und / oder dritte Teilzelle mit einer Schicht aus einer Verbindung mit wenigstens den Elementen Ga und In und As und P angesehen.

In einer Weiterbildung liegt die Gitterkonstante der ersten Schicht und / oder die Gitterkonstante der zweiten Schicht in einem Bereich zwischen 5,640 Å und 5,670 Å.

In einer anderen Weiterbildung liegt die Gitterkonstante der ersten Schicht und / oder die Gitterkonstante der zweiten Schicht in einem Bereich zwischen 5,645 Å und 5,665 Å.

In einer Ausführungsform unterscheidet sich die Gitterkonstante der ersten Schicht von der Gitterkonstante der zweiten Schicht um weniger als 0,2%. Vorzugsweise ist die Gitterkonstante der dritten Schicht größer als 5,730 Å.

Erfindungsgemäß besteht wenigstens eine der beiden Schichten aus einer Verbindung mit wenigstens den Elementen Ga und In und As und P und weist einen Phosphor-Gehalt größer als 1% und kleiner als 35% und einen Indium-Gehalt größer als 1% auf.

In einer Ausführungsform weisen beide Schichten eine Dicke größer als 0,4 µm oder größer als 0,8 µm auf.

In einer anderen Ausführungsform bestehen die beiden Schichten der zweiten Teilzelle bzw. der dritten Teilzelle aus einer Verbindung mit wenigstens den Elementen Ga und In und As und P.

In einer Weiterbildung ist eine vierte Teilzelle vorgesehen, wobei die vierte Teilzelle eine vierte Schicht aus einer Verbindung mit wenigstens den Elementen Ga und In und As umfasst und die Energiebandlücke der vierten Schicht um mindestens 0,15 eV kleiner ist als die Energiebandlücke der dritten Schicht und die Dicke der vierten Schicht größer als 100 nm ist und die vierte Schicht als Teil des Emitters und Teil der Basis ausgebildet ist. in einer anderen Weiterbildung besteht die vierte Schicht aus einer Verbindung mit wenigstens den Elementen Ga und In und As und P und weist einen Phosphor-Gehalt größer als 1% und als kleiner 35% und einen Indium-Gehalt größer als 1% auf.

In einer Ausführungsform ist ein Halbleiterspiegel zwischen zwei Teilzellen ausgebildet oder der Halbleiterspiegel ist unter der untersten Teilzelle mit der niedrigsten Energiebandlücke angeordnet.

In einer Weiterbildung besteht die erste Schicht der ersten Teilzelle aus einer

Verbindung mit wenigstens den Elementen Al und Ga und In und P. Vorzugsweise weist die

Mehrfach-Solarzelle keine Ge Teilzelle auf.

In einer Ausführungsform ist ein zweiter metamorpher Puffer zwischen der dritten Teilzelle und der vierten Teilzelle ausgebildet.

In einem Beispiel (nicht Teil der beanspruchten Erfindung) weist die Mehrfach-Solarzelle mindestens vier Teilzellen auf, wobei die dritte Schicht aus einer Verbindung mit wenigstens den

Elementen Ga und In und As und P besteht und einen Phosphor-Gehalt größer als 50% aufweist und die Mehrfachsolarzelle genau einen metamorphen Puffer aufweist und / oder sich die Gitterkonstanten der vierten Schicht von der Gitterkonstanten der dritten Schicht um weniger als 0,3% unterscheidet.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben auch keine ableitbaren geometrischen Relationen zueinander auf. Darin zeigt:
- Figur 1a: einen Querschnitt auf eine erfindungsgemäße Ausführungsform als Tripel-Solarzelle in einer ersten Alternative,
- Figur 1b: einen Querschnitt auf eine erfindungsgemäße Ausführungsform als Tripel-Solarzelle in einer zweiten Alternative,
- Figur 1c: einen Querschnitt auf eine erfindungsgemäße Ausführungsform als Tripel-Solarzelle in einer dritten Alternative,
- Figur 2a: einen Querschnitt auf eine erfindungsgemäße Ausführungsform als Vierfach-Solarzelle in einer ersten Alternative,
- Figur 2b: einen Querschnitt auf eine erfindungsgemäße Ausführungsform als Vierfach -Solarzelle In einer zweiten Alternative,
- Figur 2c: einen Querschnitt auf eine erfindungsgemäße Ausführungsform als Vierfach -Solarzelle in einer dritten Alternative,
- Figur 2d: einen Querschnitt auf eine erfindungsgemäße Ausführungsform als Vierfach -Solarzelle in einer vierten Alternative.

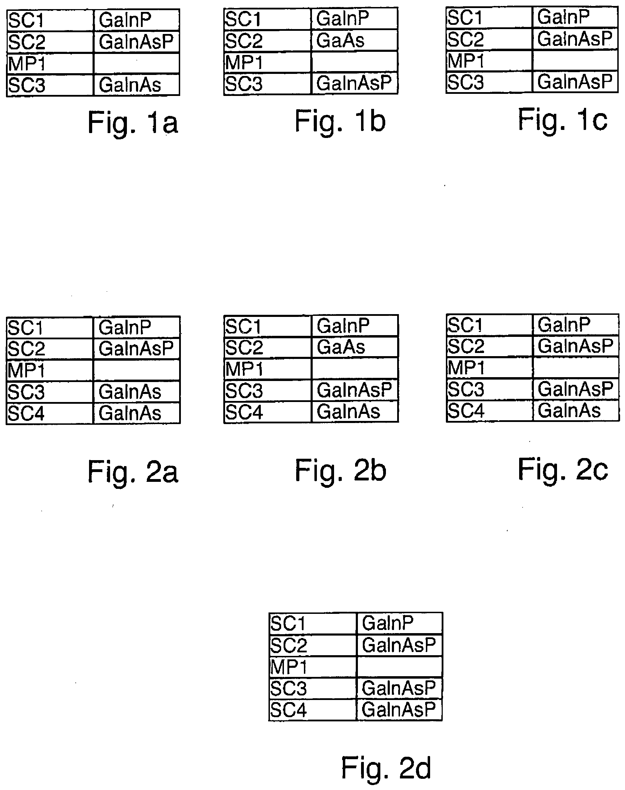

Die Abbildung der Figur 1a zeigt einen Querschnitt auf eine erste erfindungsgemäße Ausführungsform einer stapelförmigen monolithischen Mehrfach-Solarzelle, im Folgenden werden die einzelnen Solarzellen des Stapels als Teilzelle bezeichnet. Die Mehrfach-Solarzelle weist eine erste Teilzelle SC1 auf, wobei die erste Teilzelle SC1 aus einer GaInP Verbindung besteht und die größte Bandlücke des gesamten Stapels oberhalb von 1.75 eV aufweist. Unterliegend der ersten Teilzelle SC1 ist eine zweite Teilzelle SC2 bestehend aus einer GaInAsP - Verbindung angeordnet. Die zweite Teilzelle SC2 weist eine kleinere Bandlücke als die erste Teilzelle SC1 auf. Unterliegend unter der zweiten Teilzelle SC2 ist eine dritte Teilzelle SC3 bestehend aus einer InGaAs Verbindung angeordnet, wobei die dritte Teilzelle SC3 die kleinste Bandlücke aufweist. Vorliegend weist die dritte Teilzelle SC23 eine Energiebandlücke kleiner als 1.25 eV auf.

Zwischen der zweite Teilzelle SC2 und der dritten Teilzelle SC3 ist ein metamorpher Puffer MP1 ausgebildet. Der Puffer MP1 besteht aus einer Vielzahl von im Einzelnen nicht dargestellten Schichten, wobei die Gitterkonstante innerhalb des Puffers MP1 von Schicht zu Schicht des Puffers MP1 in Richtung zu der dritten Teilzelle SC3 im Allgemeinen sich erniedrigt. Eine Einführung des Puffers MP1 ist vorteilhaft, wenn die Gitterkonstante der dritten Teilzelle SC3 nicht mit der Gitterkonstante der zweiten Teilzelle SC2 übereinstimmt.

Es versteht sich, dass zwischen den einzelnen Teilzelle SC1, SC2 und SC3 jeweils eine Tunneldiode - nicht dargestellt - ausgebildet ist.

Es versteht sich auch, dass jede der drei Teilzellen SC1, SC2 und SC3 jeweils einen Emitter und eine Basis aufweist, wobei die Dicke der zweiten Teilzelle SC2 größer als 0,4 µm ausgebildet ist.

Die Gitterkonstante der ersten Teilzelle SC1 und die Gitterkonstante der zweite Teilzelle SC2 sind zueinander angepasst, bzw. stimmen miteinander überein. Anders ausgedrückt, die Teilzellen SC1 und SC2 sind zueinander "gitterangepasst".

Indem die Bandlücke der ersten Teilzelle SC1 ist größer als die Bandlücke der zweiten Teilzelle SC2 und die Bandlücke der zweiten Teilzelle SC2 größer als die Bandlücke der dritten Teilzelle SC3 ist, findet die Sonneneinstrahlung durch die Oberfläche der ersten Teilzelle SC1 statt.

Die Figur 1b zeigt einen Querschnitt auf eine erfindungsgemäße Ausführungsform als Tripel-Solarzelle in einer zweiten Alternative. Nachfolgend werden nur die Unterschiede zu der Ausführungsform, dargestellt in Zusammenhang mit der Abbildung 1a, erläutert. Hiernach besteht die zweite Teilzelle SC2 aus einer GaAs Verbindung und die dritte Tellzelle SC3 aus einer GaInAsP-Verbindung.

Die Figur 1c zeigt einen Querschnitt auf eine erfindungsgemäße Ausführungsform als Tripel-Solarzelle in einer dritten Alternative. Nachfolgend werden nur die Unterschiede zu der Ausführungsform, dargestellt in Zusammenhang mit der Abbildung 1a, erläutert. Hiernach besteht die zweite Teilzelle SC2 und die dritte Teilzelle SC3 jeweils aus einer GaInAsP-Verbindung.

Die Figur 2a zeigt einen Querschnitt auf eine erfindungsgemäße Ausführungsform als Vierfach-Solarzelle in einer ersten Alternative. Nachfolgend werden nur die Unterschiede zu der Ausführungsform, dargestellt in Zusammenhang mit der Abbildung 1a, erläutert. Unterhalb der dritten Teilzelle SC3 ist einer eine vierte Teilzelle SC4 bestehend auf einer GaInAs- Verbindung ausgebildet. Die Gitterkonstante der vierten Tellzelle SC4 und der dritten Teilzelle SC3 sind zueinander angepasst, bzw. stimmen miteinander überein.

Die vierte Teilzelle SC4 weist eine kleinere Bandlücke als die dritte Teilzelle SC3 auf.

Die Figur 2b zeigt einen Querschnitt auf eine erfindungsgemäße Ausführungsform als Vierfach-Solarzelle in einer zweiten Alternative. Nachfolgend werden nur die Unterschiede zu den vorangegangenen Ausführungsformen erläutert. Die zweite Teilzelle SC2 besteht aus einer GaAs-Verbindung und die dritte Teilzelle SC3 besteht nunmehr aus einer InGaAsP -Verbindung.

Die Figur 2c zeigt einen Querschnitt auf eine erfindungsgemäße Ausführungsform als Vierfach-Solarzelle in einer dritten Alternative. Nachfolgend werden nur die Unterschiede zu der Ausführungsform, dargestellt in der Figur 2a, erläutert. Die dritte Teilzelle SC3 besteht aus einer GaInAsP-Verbindung.

Die Figur 2d zeigt einen Querschnitt auf eine erfindungsgemäße Ausführungsform als Vierfach-Solarzelle in einer vierten Alternative. Nachfolgend werden nur die Unterschiede zu der Ausführungsform, dargestellt in der Figur 2a, erläutert. Die dritte Teilzelle SC3 und die vierte Teilzelle SC4 bestehen jeweils aus einer GaInAsP-Verbindung.

## Patentansprüche

1. Stapelförmige Mehrfach-Solarzelle umfassend
- mindestens drei Teilzellen (SC1, SC2, SC3), wobei jede der drei Teilzellen (SC1, SC2, SC3) einen Emitter und eine Basis aufweist,
- wobei die erste Teilzelle (SC1) eine erste Schicht aus einer Verbindung mit wenigstens den Elementen Ga und In und P umfasst und die Energiebandlücke der ersten Schicht größer als 1,75 eV ist und die Gitterkonstante der ersten Schicht im Bereich zwischen 563,5 pm und 567,5 pm liegt,
- wobei die zweite Teilzelle (SC2) eine zweite Schicht aus einer Verbindung mit wenigstens den Elementen Ga und As umfasst und die Energiebandlücke der zweiten Schicht im Bereich zwischen 1,35 eV und 1,70 eV liegt und die Gitterkonstante der zweiten Schicht im Bereich zwischen 563,5 pm und 567,5 pm liegt,
- wobei die dritte Teilzelle (SC3) eine dritte Schicht aus einer Verbindung mit wenigstens den Elementen Ga und In und As umfasst und die Energiebandlücke der dritten Schicht kleiner als 1,25 eV ist und die Gitterkonstante der dritten Schicht größer 570,0 pm ist,
- wobei die Dicke der drei Schichten größer als 100 nm ist und die drei Schichten als Teil des Emitters und als Teil der Basis der entsprechenden drei Teilzellen (SC1, SC2, SC3) ausgebildet sind, und einen metamorphen Puffer (MP1), wobei der metamorphe Puffer (MP1) zwischen der zweiten Teilzelle (SC2) und der dritten Teilzelle (SC3) ausgebildet ist und der metamorphe Puffer (MP1) eine Abfolge von mindestens drei Schichten aufweist und die Gitterkonstanten der Schichten des Puffers größer als die Gitterkonstante der zweiten Schicht der zweiten Teilzelle (SC2) sind und die Gitterkonstante der Schichten des Puffers bei der Abfolge in Richtung zu der dritten Teilzelle von Schicht zu Schicht ansteigt,
- wobei zwischen jeweils zwei Teilzellen des Stapels kein Halbleiterbond ausgebildet und kein Substrat angeordnet ist, wobei mindestens die zweite Schicht oder die dritte Schicht oder die zweite und die dritte Schicht der Teilzellen aus einer Verbindung mit wenigstens den Elementen Ga und In und As und P besteht und einen Phosphor-Gehalt größer als 1% und kleiner als 35% aufweist und einen Indium-Gehalt größer als 1% aufweist.

2. Mehrfach-Solarzelle nach Anspruch 1, wobei die Gitterkonstante der ersten Schicht oder die Gitterkonstante der zweiten Schicht oder die Gitterkonstanten der ersten und der zweiten Schicht in einem Bereich zwischen 564,0 pm und 567,0 pm liegen.

3. Mehrfach-Solarzelle nach einem der vorangegangenen Ansprüche, wobei die Gitterkonstante der ersten Schicht oder die Gitterkonstante der zweiten Schicht oder die Gitterkonstanten der ersten und der zweiten Schicht in einem Bereich zwischen 564,5 pm und 566,5 pm liegen.

4. Mehrfach-Solarzelle nach einem der vorangegangenen Ansprüche, wobei sich die Gitterkonstante der ersten Schicht von der Gitterkonstante der zweiten Schicht um weniger als 0,2% unterscheidet.

5. Mehrfach-Solarzelle nach einem der vorangegangenen Ansprüche, wobei die Gitterkonstante der dritten Schicht größer als 573,0 pm ist.

6. Mehrfach-Solarzelle nach einem der vorangegangenen Ansprüche, wobei die Mehrfach-Solarzelle eine vierte Teilzelle (SC4) aufweist, wobei die vierte Teilzelle (SC4) eine vierte Schicht aus einer Verbindung mit wenigstens den Elementen Ga und In und As umfasst und die Energiebandlücke der vierten Schicht um mindestens 0,15 eV kleiner ist als die Energiebandlücke der dritten Schicht und die Dicke der vierten Schicht größer als 100 nm ist und die vierte Schicht (S4) als Teil des Emitters und als Teil der Basis ausgebildet ist.

7. Mehrfach-Solarzelle nach Anspruch 6, wobei die vierte Schicht aus einer Verbindung mit wenigstens den Elementen Ga und In und As und P besteht und einen Phosphor-Gehalt größer als 1% und kleiner als 35% aufweist und einen Indium-Gehalt größer als 1% aufweist.

8. Mehrfach-Solarzelle nach einem der vorangegangenen Ansprüche, wobei ein Halbleiterspiegel zwischen zwei Teilzellen ausgebildet ist oder der Halbleiterspiegel unter der untersten Teilzelle mit der niedrigsten Energiebandlücke angeordnet ist.

9. Mehrfach-Solarzelle nach einem der vorangegangenen Ansprüche, wobei die erste Schicht der ersten Teilzelle (SC1) aus einer Verbindung mit wenigstens den Elementen Al und Ga und In und P besteht.

10. Mehrfach-Solarzelle nach einem der vorangegangenen Ansprüche, wobei die Mehrfach-Solarzelle keine Ge Teilzelle aufweist.

11. Mehrfach-Solarzelle nach einem der vorangegangenen Ansprüche, wobei ein zweiter metamorpher Puffer zwischen der dritten Teilzelle (SC3) und der vierten Teilzelle (SC4) ausgebildet ist.

## Claims

1. Stack-shaped multiple solar cell comprising
- at least three part cells (SC1, SC2, SC3), wherein each of the three part cells (SC1, SC2, SC3) comprises am emitter and a base,
- wherein the first part cell (SC1) comprises a first layer of a compound with at least the elements Ga and In and P and the energy band gap of the first layer is greater than 1.75 eV and the lattice constant of the first layer lies in the range between 563.5 pm and 567.5 pm,
- wherein the second part cell (SC2) comprises a second layer of a compound with at least the elements Ga and As and the energy band gap of the second layer lies in the range between 1.35 eV and 1.70 eV and the lattice constant of the second layer lies in the range between 563.5 pm and 567.5 pm,
- wherein the third part cell (SC3) comprises a third layer of a compound with at least the elements Ga and In and As and the energy band gap of the third layer is smaller than 1.25 eV and the lattice constant of the third layer is greater than 570.0 pm,
- wherein the thickness of the three layers is greater than 100 nm and the three layers are constructed as part of the emitter and as part of the base of the corresponding three part cells (SC1, SC2, SC3),
and a metamorphic buffer (MP1), wherein the metamorphic buffer (MP1) is formed between the second part cell (SC2) and the third part cell (SC3) and the metamorphic buffer (MP1) comprises a sequence of at least three layers and the lattice constants of the layers of the buffer are greater than the lattice constant of the second layer of the second part cell (SC2) and the lattice constant of the layers of the buffer increases from layer to layer in the sequence in the direction towards the third part cell,
- wherein no semiconductor bond is formed and no substrate is arranged between each two part cells of the stack,
wherein at least the second layer or the third layer or the second and third layers of the part cells consists or consist of a compound with at least the elements Ga and In and As and P and has or have a phosphorous content greater than 1% and less than 35% and an indium content greater than 1%.

2. Multiple solar cell according to claim 1, wherein the lattice constant of the first layer or the lattice constant of the second layer or the lattice constants of the first and second layers lies or lie in a range between 564.0 pm and 567.0 pm.

3. Multiple solar cell according to one of the preceding claims, wherein the lattice constant of the first layer or the lattice constant of the second layer or the lattice constants of the first and second layers lies or lie in a range between 564.5 pm and 566.5 pm.

4. Multiple solar cell according to any one of the preceding claims, wherein the lattice constant of the first layer differs from the lattice constant of the second layer by less than 0.2%.

5. Multiple solar cell according to any one of the preceding claims, wherein the lattice constant of the third layer is greater than 573.0 pm.

6. Multiple solar cell according to any one of the preceding claims, wherein the multiple solar cell comprises a fourth part cell (SC4), wherein the fourth part cell (SC4) comprises a fourth layer of a compound with at least the elements Ga and In and As and the energy band gap of the fourth layer is smaller by at least 0.15 eV than the energy band gap of the third layer and the thickness of the fourth layer is greater than 100 nm and the fourth layer (S4) is formed as part of the emitter and as part of the base.

7. Multiple solar cell according to claim 6, wherein the fourth layer consists of a compound with at least the elements Ga and In and As and P and has a phosphorous content greater than 1% and less than 35% and an indium content greater than 1%.

8. Multiple solar cell according to any one of the preceding claims, wherein a semiconductor mirror is formed between two part cells or the semiconductor mirror is arranged under the lowermost part cell with the lowest energy band gap.

9. Multiple solar cell according to any one of the preceding claims, wherein the first layer of the first part cell (SC1) consists of a compound with at least the elements Al and Ga and In and P.

10. Multiple solar cell according to any one of the preceding claims, wherein the multiple solar cell does not comprise any Ge part cells.

11. Multiple solar cell according to any one of the preceding claims, wherein a second metamorphic buffer is formed between the third cell part (SC3) and the fourth part cell (SC4).

## Revendications

1. Cellule solaire à jonctions multiples (MS) en forme de pile comprenant
- au moins trois sous-cellules (SC1, SC2, SC3), chacune des trois sous-cellules (SC1, SC2, SC3) comportant un émetteur et une base,
- la première sous-cellule (SC1) comprenant une première couche faite d'un composé avec au moins les éléments Ga et In et P, la bande d'énergie interdite de la première couche étant supérieure à 1,75 eV et la constante de réseau de la première couche étant située dans la plage de 563,5 pm à 567,5 pm,
- la deuxième sous-cellule (SC2) comprenant une deuxième couche faite d'un composé avec au moins les éléments Ga et As, la bande d'énergie interdite de la deuxième couche étant située entre 1,35 eV et 1,70 eV et la constante de réseau de la deuxième couche étant située dans la plage de 563,5 pm à 567,5 pm,
- la troisième sous-cellule (SC3) comprenant une troisième couche faite d'un composé avec au moins les éléments Ga et In et As, la bande d'énergie interdite de 1a troisième couche étant inférieure à 1,25 eV et la constante de réseau de la troisième couche étant supérieure à 567,5 pm,
- l'épaisseur des trois couches étant supérieure à 100 nm et les trois couches étant configurées comme une partie de l'émetteur et comme une partie de 1a base des trois sous-cellules (SC1, SC2, SC3) respectives et
un tampon métamorphique (MP1), lequel tampon métamorphique (MP1) est formé entre la deuxième sous-cellule (SC2) et la troisième sous-cellule (SC3) et lequel tampon métaphorique (MP1) présente une succession d'au moins trois couches, les constantes de réseau des couches du tampon étant supérieures à la constante de réseau de 1a deuxième couche de la deuxième sous-cellules (SC2) et la constante de réseau des couches du tampon augmentant successivement de couche en couche en direction de la troisième sous-cellule,
- aucune liaison de semi-conducteur n'étant formée et aucun substrat n'étant agencé entre deux sous-cellules de 1a pile, et
au moins la deuxième couche ou la troisième couche ou la deuxième et la troisième couches des sous-cellules étant constituées d'au moins un des éléments Ga et In et As et P et présentant une teneur en phosphore supérieure à 1% et inférieure à 35% et une teneur en Indium supérieure à 1%.

2. Cellule solaire à jonctions multiples selon la revendication 1, dans laquelle la constante de réseau de 1a première couche ou la constante de réseau de la deuxième couche ou les constantes de réseau de la première et de la deuxième couche sont situées dans une plage de 564,0 pm à 567,0 pm.

3. Cellule solaire à jonctions multiples selon une des revendications précédentes, dans laquelle la constante de réseau de la deuxième couche ou les constantes de réseau de 1a première et de 1a deuxième couche sont situées dans une plage de 564,5 pm à 566,5 pm.

4. Cellule solaire à jonctions multiples selon une des revendications précédentes, dans laquelle la constante de réseau de la première couche se différencie de la constante de réseau de la deuxième couche de moins de 0,2%.

5. Cellule solaire à jonctions multiples selon une des revendications précédentes, dans laquelle la constante de réseau de la troisième couche est supérieure à 573,0 pm.

6. Cellule solaire à jonctions multiples selon une des revendications précédentes, laquelle cellule solaire à jonctions multiples comporte une quatrième sous-cellule (SC4), la quatrième sous-cellule (SC4) comprenant une quatrième couche faite d'un composé avec au moins les éléments Ga et In et As, la bande d'énergie interdite de la quatrième couche étant inférieure d'au moins 0,15 eV à la bande d'énergie interdite de la troisième couche, l'épaisseur de la quatrième couche étant supérieure à 100 nm et la quatrième couche (S4) étant configurée comme une partie de l'émetteur et comme une partie de la base.

7. Cellule solaire à jonctions multiples selon la revendication 6, dans laquelle la quatrième couche est constituée d'un composé avec au moins les éléments Ga et In et As et P et présente une teneur en phosphore supérieure à 1% et inférieure à 35% et une teneur en indium supérieure à 1%.

8. Cellule solaire à jonctions multiples selon une des revendications précédentes, dans laquelle un miroir semi-conducteur est formé entre deux sous-cellules ou ce miroir semi-conducteur est agencé sous la sous-cellule inférieure présentant la bande d'énergie interdite 1a plus faible.

9. Cellule solaire à jonctions multiples selon une des revendications précédentes, dans laquelle la première couche de la première sous-cellule (SC1) est faite d'un composé avec au moins les éléments Al et Ga et In et P.

10. Cellule solaire à jonctions multiples selon une des revendications précédentes, laquelle cellule solaire à jonctions multiple ne comporte pas de sous-cellule Ge.

11. Cellule solaire à jonctions multiples selon une des revendications précédentes, dans laquelle un deuxième tampon métamorphique est formé entre la troisième sous-cellule (SC3) et la quatrième sous-cellule (SC4).
